# EUROPÄISCHE PATENTSCHRIFT

(11) **EP 2 336 752 B1**
(45) Veröffentlichungstag und Bekanntmachung des Hinweises auf die Patenterteilung: **05.12.2018**
(21) Anmeldenummer: 09015703.3
(22) Anmeldetag: 18.12.2009
(51) Int. Cl.: G01N 21/66, G01R 31/26, G01R 31/308, G01N 21/95, H02S 50/10

(54) **Verfahren und Vorrichtung zum Auffinden von Fehlstellen in Halbleiterbauelementen**
Method and device for determining defective points in semiconductor components
Procédé et dispositif de recherche d'endroits défectueux dans des composants semi-conducteurs

(43) Veröffentlichungstag der Anmeldung: 22.06.2011
(73) Patentinhaber: ISRA VISION Graphikon GmbH, 10409 Berlin (DE)
(72) Erfinder: Seeger, Gregor, 14478 Potsdam (DE); Lauter, Markus, 13351 Berlin (DE); Schlegel, Jan, 10117 Berlin (DE)
(74) Vertreter: Obst, Bernhard

(56) Entgegenhaltungen:
- US-A1- 2004 085 083
- US-A1- 2005 252 545
- BOTHE K ET AL: "Luminescence emission from forward- and reverse-biased multicrystalline silicon solar cells" JOURNAL OF APPLIED PHYSICS, AMERICAN INSTITUTE OF PHYSICS. NEW YORK, US LNKD- DOI:10.1063/1.3256199, Bd. 106, Nr. 10, 23. November 2009 (2009-11-23), Seiten 104510-1-104510-8, XP012127177 ISSN: 0021-8979
- KWAPIL WOLFRAM ET AL: "Diode breakdown related to recombination active defects in block-cast multicrystalline silicon solar cells" JOURNAL OF APPLIED PHYSICS, AMERICAN INSTITUTE OF PHYSICS. NEW YORK, US LNKD- DOI:10.1063/1.3224908, Bd. 106, Nr. 6, 25. September 2009 (2009-09-25), Seiten 63530-1-63530-7, XP012123994 ISSN: 0021-8979
- HONSBERG C ET AL: "LIGHT EMISSION AS A SOLAR CELL ANALYSIS TECHNIQUE" SOLAR CELLS, ELSEVIER SEQUOIA.S.A. LAUSANNE, CH LNKD- DOI:10.1016/0379-6787(87)90021-4, Bd. 20, Nr. 1, 1. Februar 1987 (1987-02-01), Seiten 59-63, XP001109755
- O. BREITENSTEIN ET AL.: "Quantitative Evaluation of Shunts in Solar Cells by Lock-In Thermography" PROGRESS IN PHOTOVOLTAICS : RESEARCH AND APPLICATIONS, Bd. 11, 2003, Seiten 515-526, XP002583700 DOI: 10.1002/pip.520
- ORDAZ M A ET AL: "Machine vision for solar cell characterization" PROCEEDINGS OF THE SPIE, Bd. 3966, 2000, Seiten 238-248, XP002521724 ISSN: 0277-786X [gefunden am 2003-06-05]

## Beschreibung

Die Erfindung betrifft ein Verfahren und eine Vorrichtung zum Auffinden von Fehlstellen, insbesondere Mikrorissen, in Halbleiterbauelementen, insbesondere flächig ausgedehnten Haltleiterelementen wie beispielsweise Solarzellen.

Halbleiterbauelemente haben eine große technische Bedeutung erlangt. Flächig ausgedehnte Halbleiterbauelemente, wie beispielsweise Solarzellen, spielen eine immer wichtigere Rolle in der Energieerzeugung. Bei der Herstellung von marktfähigen Produkten, beispielsweise fertigen Solarpaneelen, erfolgen eine Reihe von Wertschöpfungsprozessen nach dem eigentlichen Herstellen des Halbleiterbauelements, beispielsweise der Solarzelle. An diesen können unterschiedliche Fehlstellen während der Herstellung auftreten. Ein Teil von diesen führt dazu, dass das Halbleiterbauelement und/oder ein hiermit hergestelltes Produkt nur eingeschränkt funktionsfähig oder gar nicht funktionsfähig sind oder hinsichtlich seiner Stabilität oder Haltbarkeit stark eingeschränkt sind. Daher ist es aus dem Stand der Technik bekannt, die Halbleiterbauelemente bereits während der Fertigung auf Fehlstellen zu überwachen und gegebenenfalls defekte oder minderwertige Halbleiterbauelemente auszusortieren.

Aus dem Stand der Technik ist es bekannt, dass Halbleiterbauelemente, wie beispielsweise Solarzellen, wenn diese in Durchlassrichtung von einem Strom durchflossen werden, eine Lichtemission zeigen. Dieser Effekt ist als Elektrolumineszenz bekannt. Bei flächig ausgedehnten Halbleiterbauelementen lässt sich anhand der ortsaufgelösten Intensität der Elektrolumineszenzstrahlung auf Fehlstellen in dem Halbleiterbauelement schließen. Diese können unterschiedliche Ursachen haben. Die Fehlstellen können beispielsweise durch Verunreinigungen in dem Halbleiterbaumaterial, fehlerhafte Dotierungen aber auch mechanische Schäden wie beispielsweise Mikrorisse verursacht sein. Während einige dieser Fehlstellen auf die Funktionsweise und eine Lebensdauer nur einen geringen Einfluss haben, haben andere Fehlstellen, wie beispielsweise Mikrorisse, auf die weitere Lebensdauer und Nutzbarkeit des Halbleiterbauelements einen entscheidenden Einfluss.

Aus dem Stand der Technik ist es bekannt, die Elektrolumineszenzstrahlung ortsaufgelöst zu erfassen und auszuwerten, um die einzelnen Fehlstellen zu erkennen und vorzugsweise zu charakterisieren. Es hat sich jedoch gezeigt, dass ein sehr hoher Auswertungsaufwand notwendig ist, um Mikrorisse auf diese Weise zu identifizieren. Teilweise lassen sich diese gar nicht zuverlässig detektieren.

Aus der EP 1 416 288 A1 sind ein Verfahren und eine Anordnung zur optischen Detektion mechanischer Defekte in Halbleiterbauelementen, insbesondere in Solarzellenanordnungen, mit zumindest einem pn-Übergang und zumindest einer Halbleiterschicht aus einem Halbleitermaterial mit direktem Bandübergang bekannt, wobei an dem zumindest einem pn-Übergang eine Spannung zum Betrieb des pn-Überganges in Durchlassrichtung angelegt wird und das durch die angelegte Spannung erzeugte Strahlungsverhalten der Halbleiterschicht zumindest für Teilbereiche der Halbleiterschicht optisch erfasst und ausgewertet wird. Abrupte Kontrastwechsel im Strahlungsverhalten werden zum Auffinden von mechanischen Defekten genutzt. Nicht strahlende oder eine anormale Photonenimmission aufweisende Bereiche können durch inaktive Bereiche oder auch Eintrübungen oder Verschmutzungen sowie mechanische Defekte hervorgerufen sein. Insbesondere ein Auffinden und Unterscheiden von mechanischen Mikrorissen von anderen Defekten ist im Stand der Technik nur unzureichend oder über sehr aufwendige Bildverarbeitungssoftware möglich.

Die US 2004/0085083 A1 beschreibt ein Verfahren zum Ausführen einer Rückseitenphotoemissionsmikroskopie, um auf der Waferebene eine Fehleranalyse auszuführen. Das Verfahren sieht vor, dass ein als Defekt erkannter Chip mit einer Spannung beaufschlagt wird, die entgegengesetzt zu der normalen Spannungsrichtung gepolt ist. Die Rückseite des Wafers wird daraufhin betrachtet. Der Chip zeigt aufgrund einer Elektron-Loch-Kombination einer Schutzdiode eine helle Illumination. Somit ist es leicht möglich, den kaputten Chip auf der Rückseite des Wafers zu identifizieren und anschließend eine Photoemissionsmikroskopie bei gewöhnlicher betriebsgemäßer Spannungsversorgung auszuführen.

Weitere Verfahren zum Untersuchen von Solarzellen, insbesondere mittels so genannter Lock-In Thermography sind aus den Artikeln von K. Bothe et al. "Luminescence emission from forward- and reverse-biased multicrystalline silicon solar cells", Jornal of Applied Physics, American Institute of Physics, New York, Band 106, Nr. 10, Seiten 104510-1 bis 104510-8, 23. November 2009, und Wolfram Kwapil et al. "Diode breakdown related to recombination active defects in block-cast multicrystalline silicon solar cells", Journal of Applied Physics, American Institute of Physics, New York, Band 106, Nr. 6, Seiten 63530-1 bis 63530-7, 25. September 2009, beschrieben.

Auch die US 2005/0252545 A1 beschreibt ein Verfahren zum Prüfen von Solarzellen, bei dem ein Strom in Vorwärtsrichtung für eine kurze Zeitspanne durch die Solarzellen fließt und über eine Infrarotkamera eine Auswertung erfolgt, um defekte Solarzellen zu erkennen.

Der Erfindung liegt somit die Aufgabe zugrunde, eine verbesserte Vorrichtung und ein verbessertes Verfahren zum Auffinden von Fehlstellen in Halbleiterbauelementen zu liefern, welche insbesondere eine zuverlässige und sichere Detektion von Mikrorissen als Fehlstellen ermöglichen.

Die Aufgabe wird erfindungsgemäß durch ein Verfahren mit den Merkmalen des Patentanspruchs 1 sowie eine Vorrichtung mit den Merkmalen des Patentanspruchs 7 gelöst. Vorteilhafte Ausführungsformen der Erfindung ergeben sich aus den Unteransprüchen.

Zur Lösung der Aufgabe ist vorgesehen, das Halbleiterbauelement, welches einen pn-Übergang aufweist, so mit einer Spannungs- bzw. Stromquelle zu verschalten, dass zunächst eine Spannung in Sperrrichtung an das Halbleiterbauelement angelegt ist. Anschließend wird die Spannungsrichtung geändert, so dass der pn-Übergang in Durchlassrichtung betrieben wird. Die von dem Halbleiterbauelement nach dem Ändern der Spannungsrichtung emittierte elektromagnetische Strahlung wird erfasst und ausgewertet. Hierbei wird die Intensität der Lumineszenzstrahlung, die emittiert wird, wenn der pn-Übergang in Durchlassrichtung betrieben wird, ausgewertet. Im Gegensatz zu dem aus dem Stand der Technik bekannten Verfahren wird in den Bereichen, in denen Mikrorisse als Fehlstellen auftreten, unmittelbar oder kurz nach dem Ändern der Spannungsrichtung eine sehr intensive Elektrolumineszenz beobachtet. Der Mikroriss selbst zeigt keine Elektrolumineszenz. Wenn hier von Elektrolumineszenz "an einem Mikroriss" gesprochen wird, ist immer eine Elektrolumineszenz in der Umgebung des Mikrorisses gemeint.

Insbesondere wird somit ein Verfahren zum Auffinden von Fehlstellen in einem Halbleiterbauelement mit einem pn-Übergang, insbesondere in einem flächig ausgedehnten Halbleiterbauelement, besonders.bevorzugt in einer Solarzelle, vorgeschlagen, welches die Schritte umfasst: Anlegen einer Spannung an das Halbleiterbauelement mittels einer Spannungsquelle, Erfassen elektromagnetischer Strahlung, die von dem Halbleiterbauelement ausgesandt wird, mittels mindestens eines photoempfindlichen Detektors, Auswerten der erfassten elektromagnetischen Strahlung, wobei die Spannung an das Halbleiterbauelement zunächst so angelegt wird, dass der pn-Übergang in Sperrrichtung betrieben wird und anschließend die Spannungsrichtung geändert wird, so dass der pn-Übergang des Halbleiterbauelements in Durchlassrichtung betrieben wird und mit dem photoempfindlichen Detektor eine Intensität einer Lumineszenzstrahlung erfasst wird und die Intensität nach dem Ändern der Spannungsrichtung von dem Betreiben des pn-Übergangs in der Sperrrichtung zu dem Betreiben in der Durchlassrichtung ausgewertet wird.

Eine entsprechende Vorrichtung zum Auffinden zum Fehlstellen in einem Halbleiterbauelement, insbesondere in einem flächig ausgedehnten Halbleiterbauelement, besonders bevorzugt einer Solarzelle, umfasst somit eine Spannungsquelle, die mit Kontakten des Halbleiterbauelements verbindbar ist, um an das Halbleiterbauelement eine Spannung anzulegen; mindestens einen photoempfindlichen Detektor zum Erfassen elektromagnetischer Strahlung, die von dem Halbleiterbauelement ausgesandt wird, und eine Auswerteeinrichtung zum Auswerten der erfassten von dem Halbleiterbauelement emittierten elektromagnetischen Strahlung, wobei eine Spannungsrichtungsänderungseinrichtung mit der Spannungsquelle gekoppelt ist oder in die Spannungsquelle integriert ist, über die gezielt die Spannungsrichtung der an das Halbleiterbauelement angelegten Spannung geändert werden kann, so dass von einem Betreiben eines pn-Übergangs des Halbleiterbauelements in Sperrrichtung zu einem Betreiben des pn-Übergangs gewechselt werden kann, und die mit dem mindestens einen photoempfindlichen Detektor gekoppelte Auswerteeinrichtung zum Auswerten einer Intensität einer Lumineszenzstrahlung als die elektromagnetische Strahlung nach dem Ändern der Spannungsrichtung von der Sperrrichtung auf Durchlassrichtung ausgebildet ist.

Erfindungsgemäß werden Fehlstellen anhand einer überhöhten Strahlungsintensität der Lumineszenzstrahlung nach dem Ändern der Spannungsrichtung von der Sperrrichtung auf die Durchlassrichtung erkannt. Eine einfache Auswerteeinrichtung umfasst hierfür eine Vergleichseinrichtung, welche die empfangene Intensität mit einem Schwellenwert vergleicht. Wird der Schwellenwert überschritten, so liegt eine Fehlstelle vor. Diese kann als Mikroriss identifiziert werden.

Bei einer einfachen Ausführungsform ist die Spannungsrichtungsänderungseinrichtung als Umschalteinrichtung ausgebildet.

Nach einer geeignet gewählten Zeitspanne, in der der pn-Übergang in Sperrrichtung betrieben wird, kann mit einer solchen Spannungsrichtungsänderungseinrichtung einfach von der Sperrrichtung in die Durchlassrichtung umgeschaltet werden, so dass die überhöhte Intensität an den durch Risse verursachten Fehlstellen entsteht und beobachtbar ist, d.h. in der Umgebung von Mikrorissen entsteht und beobachtbar ist. Die mit dem photoempfindlichen Detektor beobachtbare Lumineszenzstrahlung liegt in der Regel im nahen infraroten Wellenlängenbereich. Daher ist der photoempfindliche Detektor vorzugsweise als im nahen infraroten Wellenlängenbereich empfindliche Kamera ausgebildet, die die Intensität der Lumineszenzstrahlung ortsaufgelöst aufnimmt und in Form von Bildern bereitstellt. Eine Ortsauflösung wird bei einer bevorzugten Ausführungsform mit einer Flächenkamera, die beispielsweise als CCD-Chip ausgebildet ist, erfasst. Alternative Ausführungsformen können jedoch eine Zeilenkamera vorsehen. Durch ein ortsaufgelöstes Erfassen der Lumineszenzstrahlung mittels einer im vorzugsweise nahen infraroten Wellenlängenbereich empfindlichen Kamera in Form von Bildern ist es möglich, die lokal erkannten Intensitätsüberhöhungen Positionen auf dem Halbleiterbauelement zuzuordnen. Hierdurch können die detektierten Fehlstellen in Form von Mikrorissen auf dem Halbleiterbauelement zuverlässig lokalisiert werden.

Da die Lumineszenzintensität nach dem Wechsel der Spannungsrichtung auf die Durchlassrichtung zeitlich abklingt, ist bei einer Weiterbildung der Erfindung vorgesehen, dass mehrere zeitlich nacheinander aufgenommene Bilder vergleichend ausgewertet werden, um Kontrastunterschiede zur Lokalisierung auszuwerten. Zum Teil ist die Überhöhung der Lumineszenzstrahlung in der Umgebung des Mikrorisses so stark, dass dieser zunächst auf den zeitlich zuerst aufgenommenen Bildern nur grob zu lokalisieren ist, da ein größerer Umgebungsbereich des Mikrorisses die überhöhte Lumineszenzstrahlung zeigt. Mit fortschreitender Zeitdauer nach dem Wechsel der Spannungsrichtung von der Sperrrichtung auf die Durchlassrichtung nimmt die Intensität insgesamt ab. Der Mikroriss oder die Mikrorisse sind nun örtlich präziser zu lokalisieren, da keine Übersteuerungseffekte beim Erfassen der Intensität auftreten und die Lumineszenzstrahlung sich auch in der näheren Umgebung des Mikrorisses wieder dem normalen Niveau annähert. (Es wird angemerkt, dass der Mikroriss selbst nicht strahlt.) Das Auswerten mehrerer in zeitlicher Folge aufgenommener Bilder der Lumineszenzstrahlung lässt zuverlässig auf ein Abklingverhalten schließen. Ein solches Abklingverhalten zeigen nur Umgebungen von durch Mikrorisse verursachten Fehlstellen. Somit ist es anhand des ermittelten Abklingverhaltens zuverlässig möglich, Mikrorisse als Fehlstellen zu lokalisieren. Somit wird ein zeitliches Abklingen der Intensität nach dem Ändern der Spannungsrichtung von der Sperrrichtung auf die Durchlassrichtung untersucht und ein Absinken der Lumineszenzintensität als ein Kriterium für ein Vorliegen einer Fehlstelle, insbesondere eines Mikrorisses, berücksichtigt.

Bei einer Ausführungsform ist vorgesehen, dass nicht strahlende Orte des Halbleiterbauelements, die in einem Bereich liegen, in dem eine Intensitätsüberhöhung der Lumineszenzstrahlung nach dem Ändern der Spannungsrichtung von der Sperrrichtung auf die Durchlassrichtung erkannt wurde, als Orte eines Mikrorisses identifiziert werden. Entsprechend ist somit die Auswerteeinrichtung ausgebildet, dieses umzusetzen.

Bei einer bevorzugten Weiterbildung der Erfindung wird während des Betreibens des pn-Übergangs in Sperrrichtung eine so genannte Shuntmessung durchgeführt, während derer mittels einer Wärmebildkamera eine Wärmeemission das Halbleiterbauelement erfasst wird und lokale Wärmeunterschiede ausgewertet werden und insbesondere lokale Wärmeüberhöhungen als Fehlstellen (hot spots) erkannt werden. Das Einbinden einer Shuntmessung in das Verfahren verlängert die Zeitdauer des Verfahrens nicht oder nur unwesentlich und liefert zusätzliche Informationen über Fehlstellen, die aufgrund der Elektrolumineszenzmessung nicht ermittelbar sind.

Als Fehlstellen werden alle Defekte elektronischer oder mechanischer Art angesehen, die einen bestimmungsgemäßen Gebrauch des Halbleiterbauelements einschränken, dessen Lebensdauer verringern und/oder dessen Gebrauch vollständig unmöglich machen. Zum Ausführen der Shuntmessung kann entweder der mindestens eine photoempfindliche Detektor genutzt werden, sofern dieser auch im längerwelligen infraroten Wellenlängenbereich eine ausreichende Empfindlichkeit aufweist oder mindestens ein weiterer photoempfindlicher Detektor genutzt werden, der insbesondere für Wärmestrahlung, welche im längerwelligen infraroten Wellenlängenbereich angesiedelt ist, empfindlich ist.

Das Verfahren wird vorzugsweise automatisiert ausgeführt. Eine Steuerung steuert hierbei das Anlegen der Spannung, die Erfassung der elektromagnetischen Strahlung sowie deren Auswertung.

Nachfolgend wird die Erfindung unter Bezugnahme auf eine Zeichnung näher erläutert. Hierbei zeigen:
- Fig. 1: eine schematische Darstellung einer Vorrichtung zum Auffinden von Fehlstellen;
- Fig. 2: ein schematisches Flussdiagramm eines Verfahrens zum Auffinden von Fehlstellen in einem Halbleiterbauelement; und
- Fig. 3: drei Graphen, in denen die an dem Halbleiterbauelement anliegende Spannungsrichtung, eine Lumineszenzintensität in einem intakten Bereich und eine Lumineszenzintensität an einem Mikroriss jeweils aufgetragen gegen die Zeit schematisch dargestellt sind.

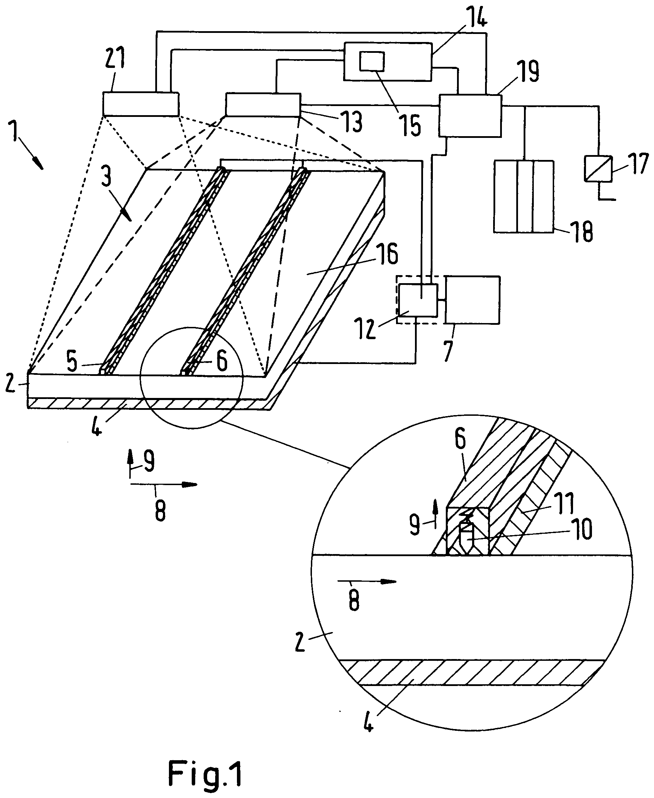

In Fig. 1 ist schematisch eine Vorrichtung zum Auffinden von Fehlstellen in einem Halbleiterbauelement dargestellt. Die Vorrichtung 1 Ist besonders geeignet, flächig ausgedehnte Halbleiterbauelemente auf Fehlstellen, d.h. fehlerhafte Orte und Bereiche des Halbleiterbauelements 2 zu untersuchen. Beispielhaft ist als Halbleiterbauelement 2 in Fig. 1 eine Solarzelle 3 dargestellt.

Die Vorrichtung 1 umfasst einen als Rückseitenkontakt 4 ausgebildeten Kontakt sowie gegenüberliegend angeordnete Vorderseitenkontakte 5, 6. Die Vorderseitenkontakte 5. 6 und der Rückseitenkontakt 4 sind so ausgeblldet, dass das Halbleiterbauelement 2, beispielsweise die Solarzelle 3, zwischen dem Rückseitenkontakt 4 und den Vorderseitenkontakten 5 und 6 anordenbar ist. In Fig. 1 ist die Solarzelle 3 zwischen dem rückseitigen Kontakt 4 und den Vorderseitenkontakten 5, 6 angeordnet. Die Anordnung erfolgt so, dass das Halbleiterbauelement elektrisch kontaktiert ist. Dies bedeutet, dass der Rückseitenkontakt 4 und die Vorderseitenkontakte 5, 6 jeweils mit elektrischen Kontakten des Halbleiterbauelements in elektrisch leitenden Kontakt sind. Die Geometrie der einzelnen Kontakte 4-6 ist jeweils angepasst an die zu untersuchenden Haltleiterbauelemente gewählt. Wie später noch erläutert wird, sind die Vorderseitenkontakte so ausgebildet, dass diese einerseits eine möglichst geringe Fläche des Halbleiterbauelements überdecken und dennoch einen ausreichend guten elektrischen Kontakt zu dem Halbleiterbauelement herstellen. Dies bedeutet, dass sie entlang einer ersten Richtung 8 jeweils eine möglichst geringe Ausdehnung aufweisen. Darüber hinaus ist es vorteilhaft, wenn die Vorderseitenkontakte auch eine geringe Bauhöhe senkrecht zur lateralen flächigen Ausdehnung des Halbleiterbauelements 2, d.h. der Solarzelle 3, aufweisen. Somit sind die Vorderseitenkontakte 5, 6 so ausgebildet, dass sie entlang einer zweiten Richtung 9, die senkrecht auf der erste Richtung 8 steht, eine geringe Ausdehnung aufweisen.

Um einen zuverlässigen Kontakt herzustellen, sind die Vorderseitenkontakte 5, 6 mit federnden Kontaktstiften 10 ausgebildet. Diese stellen den elektrischen Kontakt zu Halbleiterbauelementkontakten 11 dar.

Zwischen dem Rückseltenkontakt 4 einerseits und den Vorderseitenkontakten 5, 6 andererseits kann über eine Spannungsquelle 7 eine elektrische Spannung angelegt werden. Mit der Spannungsquelle 7 oder in die Spannungsquelle ist eine so genannte Spannungsrichtungsänderungseinrichtung 12 gekoppelt bzw. integriert. Über diese Spannungsrichtungsänderungseinrichtung 12 ist es möglich, gezielt die Spannungsrichtung, die zwischen den Vorderseitenkontakten 5, 6 und dem Rückseitenkontakt 4 anlegbar ist bzw. angelegt wird, zu wählen. Die Spannungsrichtung kann einerseits so gewählt werden, dass ein pn-Übergang des Halbleiterbauelements 2 in Durchlassrichtung betrieben wird. In diesem Fall fließt ein Strom in Durchlassrichtung durch das Halbleiterbauelement 2, so dass eine Lumineszenzstrahlung, d.h. eine elektromagnetische Strahlung, von dem Halbleiterbauelement emittiert wird. Alternativ ist es möglich, die Spannung so zwischen den Vorderseitenkontakten 5, 6 und dem Rückseitenkontakt 4 anzulegen, dass der pn-Übergang des Halbleiterbauelements 2 in Sperrrichtung betrieben wird. Bei dieser Verschaltung wird in dem Halbleiterbauelement 2 an dem pn-Übergang keine Lumineszenzstrahlung erzeugt. Die beim Anlegen einer Spannung in Durchlassrichtung, d.h. einem Betreiben des pn-Übergangs in Durchlassrichtung, erzeugte Elektrolumineszenz weist nur eine geringe Intensität auf. Um diese zu erfassen und auswerten zu können, ist ein photoempfindlicher Detektor 13 vorgesehen. Dieser ist in der dargestellten Ausführungsform als Flächenkamera ausgebildet. Dies bedeutet, dass ein flächiger Bereich, vorzugsweise die gesamte Oberfläche des Halbleiterbauelements 2, zeitgleich optisch bildlich erfassbar ist. Der photoempfindliche Detektor 13, d.h. die Flächenkamera, ist so gewählt, dass sie photoempfindlich im Wellenlängenbereich der Elektrolumineszenzstrahlung ist. Die Wellenlänge der erzeugten Elektrolumineszenzstrahlung hängt von der Bandlücke des pn-Übergangs ab. Bei Solarzellen weist die Bandlücke eine Energie auf, die einer Wellenlänge im nahen infraroten Wellenlängenbereich entspricht.

Die optisch ortsaufgelöst erfasste Intensität der Elektrolumineszenz wird von dem photoempfindlichen Detektor 13 einer Auswerteeinrichtung 14 zugeführt. In einer einfachen Ausführungsform werden lediglich erfasste Intensitätswerte mit Schwellenwerten verglichen. In weiterentwickelten Ausführungsformen erfasst der photoempfindliche Detektor 13 in zeitlicher Abfolge ortsaufgelöst die Intensität der Elektrolumineszenzstrahlung. Somit ist die Auswerteeinrichtung 14 in der Lage, ein Abklingverhalten der Elektrolumineszenz auszuwerten. Eine vergleichende Auswertung von nacheinander aufgenommenen Abbildungen ermöglicht es darüber hinaus, Kontrastuntersuchungen auszuführen, um Fehlstellen zu lokalisieren. Hierfür ist eine Vergleichseinrichtung 15 vorhanden. Während die Elektrolumineszenz in aktiven intakten Bereichen zeitlich nahezu konstant ist, ist die Elektrolumineszenzstrahlung an Mikrorissen nach einem Wechsel der Spannungsrichtung von der Sperrrichtung auf die Durchlassrichtung zunächst sehr intensiv. Die Intensität der Elektrolumineszenzstrahlung in der näheren Umgebung von Mikrorissen ist größer als in sonstigen intakten strahlenden Bereichen. Nach dem Umschalten der Bestromungsrichtung klingt jedoch die Intensität der Lumineszenzstrahlung in der näheren Umgebung von Mikrorissen bis auf das bei sonstigen intakten Bereichen übliche Maß ab. Vergleiche von Intensitätsbildem, die mit dem photoempfindlichen Detektor 13 aufgenommen sind, ermöglichen es somit, die Gebiete der Mikrorisse eindeutig zu lokalisieren. Orte, die nach einer gewissen Zeitspanne keine Lumineszenzstrahlung bei einem Betrieb des pn-Übergangs in Durchlassrichtung aufweisen, die jedoch unmittelbar nach dem Wechsel der Spannung von der Sperrrichtung auf die Durchlassrichtung eine nennenswerte Elektrolumineszenz aufweisen, können somit als Umgebung von Mikrorissen eindeutig identifiziert werden. Der Mikroriss selbst kann dann als nicht strahlende Struktur in den verschieden hellen Abklingphasen erkannt werden. Somit können Fehlstellen, die Mikrorisse enthalten, eindeutig von anderen Fehlstellen unterschieden werden, beispielsweise Verschmutzungen, Partikel, Bedruckungsfehler oder Fehler im Halbleitermaterial, die in dem aufgenommenen Bild der Elektrolumineszenz ebenfalls nach einem Abwarten der an Mikrorissen beobachtbaren Abklingzeit der Elektrolumineszenz keine Intensität zeigen.

Um eine gesamte Fläche 16 des Halbleiterbauelements 2, d.h. der Solarzelle 3, möglichst vollständig untersuchen zu können, ist es notwendig, dass die Vorderseitenkontakte 5, 6 möglichst wenig Bereiche für den photoempfindlichen Detektor verdecken. Daher ist eine möglichst geringe laterale Ausdehnung in der Ebene der Oberfläche 16 als auch eine geringe Ausdehnung senkrecht hierzu durch die Vorderseitenkontakte von Vorteil.

Die Ergebnisse der Auswertung werden entweder in Form von elektronischen Daten über eine Schnittstelle 17 bereitgestellt oder über eine Ausgabeeinrichtung 18 ausgegeben, beispielsweise über eine grafische Anzeigevorrichtung für den Nutzer visualisiert. Bei einer bevorzugten Ausführungsform wird die Untersuchung des Halbleiterbauelements 2 auf Fehlstellen durch eine elektronische Steuerung 19 gesteuert ausgeführt. Diese steuert zum einen die Spannungsquelle 7 als auch vorzugsweise die Auswerteeinrichtung 14 und gegebenenfalls zusätzlich den photoempfindlichen Detektor 13.

Neben Mikrorissen können in dem Halbleiterbauelement anhand der Untersuchung der Elektrolumineszenzstrahlung auch andere Fehlstellen des Halbleiterbauelements ermittelt werden. Dies erfolgt ebenfalls in der Auswerteeinrichtung 14 durch Auswertung der erfassten Elektrolumineszenzintensität Beispielsweise können inaktive Bereiche ermittelt werden, die beispielsweise durch Dotierungsfehler des Halbleiterbauelements oder andere Fertigungsfehler verursacht sein können.

Andere Arten von Fehlstellen, insbesondere solche, die ihre Ursache in der elektronischen Struktur des Halbleiterbauelements haben, können in einer so genannten Shuntmessung ermittelt werden. Eine solche Shuntmessung wird durchgeführt, während an dem Halbleiterbauelement 2 eine Spannung anliegt, dass der pn-Übergang in Sperrrichtung betrieben wird. Bei einer Shuntmessung wird die von dem Halbleiterbauelement 2 abgestrahlte Wärmestrahlung auf lokale Unterschiede untersucht. Die Wärmestrahlung wird entweder mit dem photoempfindlichen Detektor 13 oder mit einem weiteren photoempfindlichen Detektor 21 detektiert, der insbesondere an die Wellenlänge der Wärmestrahlung, welche im infraroten Wellenlängenbereich emittiert wird, angepasst ist.

Vorteil einer solchen Ausführungsform ist es, dass die für die Untersuchung des Halbleiterbauelements benötigte Zeit gar nicht oder nur unwesentlich verlängert wird, da zur Ermittlung der Fehlstellen, welche Risse sind, an das Halbleiterbauelement 2 zunächst eine Spannung in Sperrrichtung des pn-Übergangs angelegt werden muss, bevor die Spannungsrichtung auf die Durchlassrichtung geändert wird, um dann die Intensitätsüberhöhung der Lumineszenzstrahlung im Bereich der Mikrorisse zu beobachten.

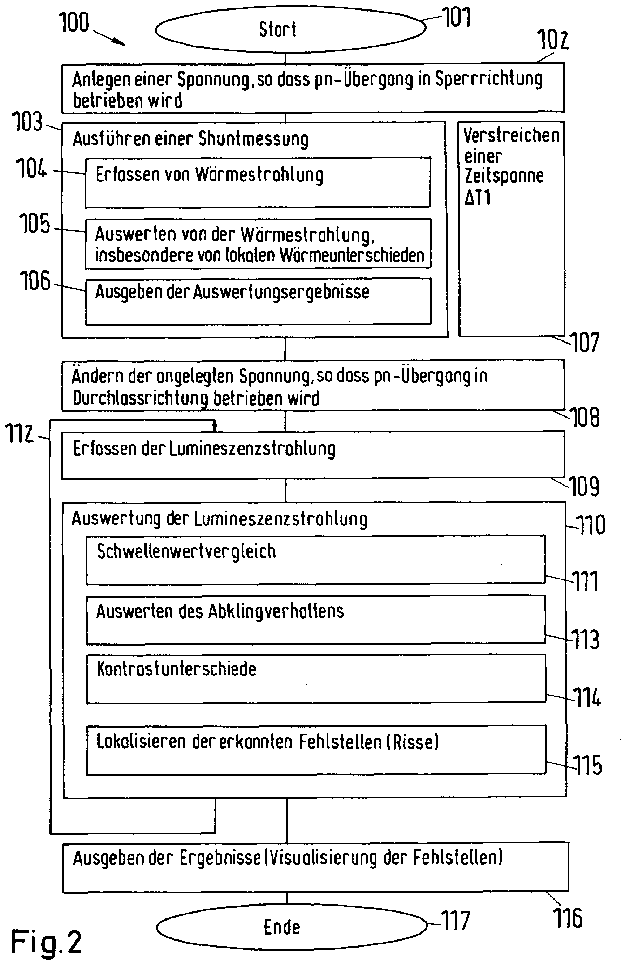

In Fig. 2 ist schematisch ein Ablaufdiagramm eines beispielhaften Verfahrens 100 zum Ermitteln von Fehlstellungen dargestellt. Nach dem Start 101 des Verfahrens wird zunächst an das Halbleiterbauelement eine Spannung so angelegt, dass ein pn-Übergang des Halbleiterbauelements in Sperrrichtung betrieben wird 102. Während der pn-Übergang in Sperrrichtung betrieben wird, wird bei der dargestellten Ausführungsform des Verfahrens 100 so genannte Shuntmessung 103 ausgeführt. Hierbei wird die von dem Halbleiterbauelement abgestrahlte Wärmestrahlung erfasst 104. Das Erfassen der Wärmestrahlung 104 erfolgt vorzugsweise ortsaufgelöst. Die erfasste Wärmestrahlung, d.h. ein Wärmeabbild der Fläche des Halbleiterbauelements wird anschließend ausgewertet 105. Hierbei wird bei einer bevorzugten Ausführungsform bei der Auswertung nach lokalen Wärmeunterschieden gesucht. Dies bedeutet, es werden Regionen oder Orte gesucht, die insbesondere eine stärkere Wärmeabstrahlung als normale intakte Bereiche des Halbleiterbauelements zeigen oder Bereiche, die eine sehr viel geringere Wärmestrahlung als normale intakte Bereiche des Halbleiterbauelements zeigen. Die so ermittelten Ergebnisse werden ausgegeben 106. Eine Ausgabe kann jedoch auch zu einem anderen Zeitpunkt des Verfahrens 100 ausgeführt werden.

Nach dem Ausführen der Shuntmessung, d.h. zumindest dem Erfassen der Wärmestrahlung 104, oder alternativ, sofern keine Shuntmessung 103 ausgeführt wird, einem Verstreichen einer angemessenen ersten Zeitspanne ΔT1 107 wird die Richtung der angelegten Spannung an das Halbleiterbauelement so geändert, dass anschließend der pn-Übergang des Halbleiterbauelements in Durchlassrichtung betrieben wird 108. Während oder anschließend an das Ändern der angelegten Spannungsrichtung wird die von dem Halbleiterbauelement emittierte Lumineszenzstrahlung erfasst 109. Die Lumineszenzstrahlung wird bei einer bevorzugten Ausführungsform ortsaufgelöst beispielsweise mit einer Flächenkamera erfasst. Bei einer solchen Flächenkamera handelt es sich vorzugsweise um einen auf Siliziumbasis hergestellten Photodetektor. Es können jedoch auch beliebige andere photoempfindliche Detektoren eingesetzt werden, die in der Lage sind, das Halbleiterbauelement flächig ortsaufgelöst zu erfassen. Beim Erfassen werden somit Intensitätsabbildungen der Lumineszenzstrahlung der Oberfläche des Halbleiterbauelements erstellt. Anschließend wird die Intensität der Lumineszenzstrahlung ausgewertet 110. Bei einer einfachen Auswertung wird die erfasste Lumineszenzintensität mit einem Schwellenwert verglichen 111. Dieses kann sowohl integriert über die gesamte Fläche als auch lokal erfolgen. Wird die Intensität integriert über die Fläche ausgewertet, so ist eine ortsaufgelöste Erfassung der Intensität nicht unbedingt erforderlich. Befindet sich in dem Sichtbereich des photoempfindlichen Detektors ein Mikroriss, so ist die nach dem Ändern der Spannungsrichtung von der Sperrrichtung auf die Durchlassrichtung deutlich gegenüber jener Intensität überhöht, die von einem intakten Halbleiterbauelement emittiert wird. Wird somit ein Schwellenwert überschritten, so ist in dem Sichtfeld, welches von dem photoempfindlichen Detektor erfasst wird, mindestens ein Mirkoriss vorhanden. Um diesen auch lokalisieren zu können, Ist eine ortsaufgelöste Erfassung und Auswertung der Lumineszenzstrahlung notwendig. Lokal kann dies erneut durch ein Vergleichen mit einem Schwellenwert erfolgen. Benachbart zu Orten, an denen sich ein Mikroriss befindet, ist nach dem Ändern der Spannungsrichtung von der Sperrrichtung auf die Durchlassrichtung zunächst eine überhöhte Lumineszenzintensität oberhalb eines Schwellenwerts zu beobachten.

Bei einer verbesserten Ausführungsform wird die Lumineszenzintensität zeitaufgelöst ausgewertet. Dieses kann sowohl bei einer integralen Erfassung bzw. integralen Auswertung der Lumineszenzintensität als auch bei der ortsaufgelösten Erfassung und Auswertung ausgeführt werden. Dieses ist über einen Pfeil 112 angedeutet. Um das Abklingverhalten der Lumineszenzintensität auswerten zu können, ist es erforderlich, dass zeitlich aufeinander folgend die Intensität der Lumineszenzstrahlung erfasst wird. Durch eine vergleichende Auswertung kann das Abklingverhalten der Lumineszenzstrahlung erfasst werden 113. Dieses Abklingverhalten stellt ein zweites Merkmal zur Identifizierung von Mikrorissen dar. An Orten in der Umgebung eines Mikrorisses klingt die Lumineszenzintensität auf ein Intensitätsniveau ab, wie dieses in intakten strahlenden Bereichen, d.h. beabstandet von Fehlstellen, beobachtet wird. Dieses Abklingen erfolgt in einer Größenordnung von in der Regel einigen Sekunden. Somit ist eine sehr schnelle Ermittlung der Mikrorisse möglich. Da das zeitliche Abklingverhalten sowie die Intensitätserhöhung durch einfache Differenzbildung oder vergleichende Auswertung ermittelbar sind, lassen sich Mikrorisse mit dem beschriebenen Verfahren ohne einen hohen Rechen- und Auswerteaufwand ermitteln. Während der Auswertung lässt sich somit sehr gut der Kontrast zwischen aktiven Bereichen und inaktiven Bereichen im Bereich von Mikrorissen ermitteln 114. Bei einer ortsaufgelösten Auswertung wird zusätzlich der Mirkoriss auf dem Halbleiterbauelement lokalisiert 115. Angemerkt wird, dass an Orten, an denen der Mikrorisse vorhanden sind, häufig zunächst auch eine Lumineszenzintensität mit einem Photodetektor beobachtet wird. Scheinbar zeigt somit auch der Mikroriss selbst eine erhöhte Lumineszenzintensität, die dann aber vollständig oder nahezu vollständig abklingt. Die Urasche hierfür ist in einem Übersteuerungsverhalten des photoempfindlichen Detektors zu suchen.

Es versteht sich für den Fachmann, dass bei der Auswertung der Lumineszenzstrahlung auch andere Arten von Fehlstellungen, d.h. inaktive Gebiete usw., ermittelt werden können.

Die ermittelten Fehlstellungen werden anschließend ausgegeben 116. Dies kann beispielsweise elektronisch in Form eines Datensatzes über eine Schnittstelle oder über eine grafische Visualisierung auf einer Anzeigevorrichtung, beispielsweise einem Bildschirm, erfolgen. Nach der Ausgabe der Fehlstellen ist das Verfahren beendet 117.

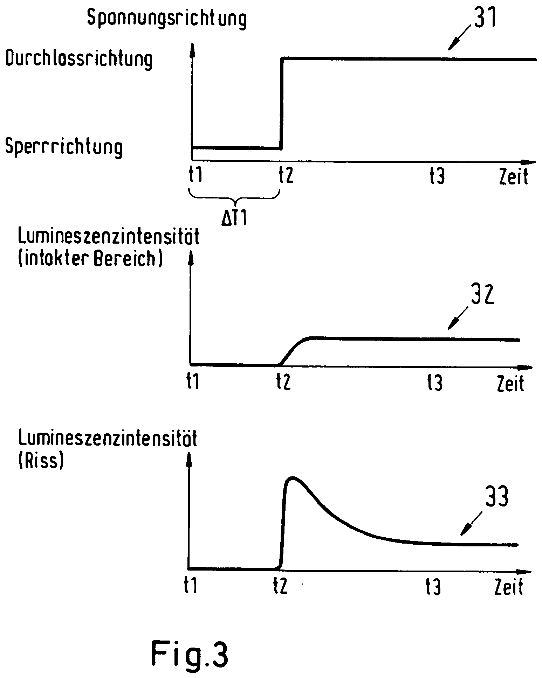

In Fig. 3 sind schematisch drei Graphen dargestellt. In einem ersten Graphen 31 ist die Spannungsrichtung, welche an das Halbleiterbauelement angelegt wird, gegen die Zeit aufgetragen. Im mittleren Graphen 32 ist die Lumineszenzintensität einer intakten Solarzelle bzw. eines intakten Bereichs einer Solarzelle gegen die Zeit aufgetragen. In dem unteren Graphen 33 ist schließlich die erfasste Lumineszenzintensität einer Solarzelle mit einem Mikroriss bzw. im Bereich eines Mikrorisses eines Halbleiterbauelements gegen die Zeit aufgetragen.

Zu einem Zeitpunkt t1 wird oder ist eine Spannung an das Halbleiterbauelement so angelegt, dass der pn-Übergang in Sperrrichtung betrieben wird. Weder im Bereich des Mikrorisses noch im intakten Bereich der Solarzelle ist eine Lumineszenzstrahlung zu beobachten. Zu einem Zeitpunkt t2 wird die Spannungsrichtung geändert, so dass nun über dem pn-Übergang die Spannung in Durchlassrichtung abfällt. In der näheren Umgebung des Mikrorisses setzt nun eine gegenüber den intakten Bereichen verstärkte Lumineszenzintensität ein. Die Intensität der Lumineszenzstrahlung in der näheren Umgebung des Mikrorisses übertrifft die Intensität der Lumineszenzstrahlung der übrigen intakten Bereiche um ein Mehrfaches. Die Änderung der Spannungsrichtung erfolgt, nachdem mindestens eine angemessene Zeitspanne ΔT1 verstrichen ist. Diese ist jeweils einfach experimentell ermittelbar und hängt unter anderem von dem Halbleitermaterial des Halbleiterbauelements und den konkret angelegten Spannungswerten. Die im Bereich des Mikrorisses einsetzende Intensität der Lumineszenzstrahlung ist jedoch deutlich gegenüber der Intensität überhöht, die im intakten Bereich der Solarzelle erfasst wird. Während die Intensität der Lumineszenzstrahlung im intakten Bereich der Solarzelle nach einem anfänglichen Anstieg zeitlich nahezu konstant bleibt, klingt die verstärkte Lumineszenzintensität im Bereich des Mikrorisses mit der Zeit deutlich ab und erreicht zu einem Zeitpunkt t3 das Niveau der übrigen intakten Bereiche. Aus dem Vergleich der Intensitätskurven für den intakten Bereich und dem Bereich des Mirkorisses ist ein deutlicher Unterschied bei der auftretenden Lumineszenzstrahlung zu erkennen, so dass eine Auswertung der intensität der Lumineszenzstrahlung sowohl hinsichtlich der beobachteten anfänglichen Lumineszenzintensität als auch einer Auswertung hinsichtlich eines zeitlichen Abklingverhaltens der Intensität jeweils ein unabhängiges Merkmal liefern, um einen Mirkoriss in einem Halbleiterbauelement zu ermitteln. Es sei an dieser Stelle angemerkt, dass die Überhöhung der Intensität der Lumineszenzstrahlung nur beobachtet wird, wenn das Halbleiterbauelement zuvor eine vorgegebene Zeitspanne, welche einfach ermittelt werden kann und von der Kontaktierung und der Ausbildung des jeweiligen Halbleiterbauelements abhängig ist, zunächst so mit einer Spannung versorgt wird, dass der pn-Übergang in Sperrrichtung betrieben wird. Erfolgt dieses nicht, so ist im Bereich des Mikrorisses keine überhöhte Lumineszenzintensität zu beobachten.

Die in Fig. 3 dargestellten Intensitäten und Zeitspannen sind nur schematisch angedeutet. Sowohl das Verhältnis der Lumineszenzintensitäten nach dem Ändern der Spannungsrichtung am Mirkoriss und im intakten Bereich als auch ein Verhältnis der angemessenen Zeitspanne ΔT1 zu der Abklingzeit der Lumineszenzintensität an dem Mikroriss sind nur exemplarisch für zwecke der Darstellung gewählt und stellen keine gemessenen oder experimentell verwendeten Werte dar. Ebenso sind die Abmessungen der einzelnen Bestandteile in Fig. 1 nur schematisch dargestellt. Insbesondere eine Ausdehnung des Halbleiterbauelements 2 senkrecht zu seiner Fläche 16 ist zur Veranschaulichung vergrößert dargestellt. Teile der Vorrichtung 1 sind zur Veranschaulichung perspektivisch angedeutet andere nur schematisch als Blöcke dargestellt.

### Bezugszeichenliste

- 1: Vorrichtung zum Auffinden von Fehlstellen
- 2: Halbleiterbauelement
- 3: Solarzelle
- 4: Rückseitenkontakt
- 5, 6: Vorderseitenkontakte
- 7: Spannungsquelle
- 8: erste Richtung
- 9: zweite Richtung
- 10: Federstifte
- 11: Halbleiterbauelementkontakte
- 12: Spannungsrichtungsänderungseinrichtung
- 13: photoempfindlicher Detektor
- 14: Auswerteeinrichtung
- 15: Vergleichseinrichtung
- 16: Fläche des Halbleiterbauelements
- 17: Schnittstelle
- 18: Ausgabeeinrichtung
- 19: Steuerung
- 21: weiterer photoempfindlicher Detektor
- 31: Graph am Halbleiterbauelement angelegte Spannung gegen die Zeit
- 32: Graph Lumineszenzintensität in einem intakten Bereich aufgetragen gegen die Zeit
- 33: Graph Lumineszenzintensität im Bereich eines Mikrorisses aufgetragen gegen die Zeit
- 100: Verfahren zum Auffinden von Fehlstellen
- 101: Start
- 102: Anlegen einer Spannung in Sperrrichtung
- 103: Ausführen einer Shuntmessung
- 104: Erfassen von Wärmestrahlung
- 105: Auswerten der erfassten Wärmestrahlung
- 106: Ausgeben der Ergebnisse
- 107: Verstreichen einer Zeitspanne ΔT1
- 108: Ändern der Spannungsrichtung, so dass ein pn-Übergang des Halbleiterbauelements in Durchlassrichtung betrieben wird
- 109: Erfassen der Lumineszenzstrahlung
- 110: Auswerten der Lumineszenzstrahlungsintensität
- 111: Vergleich der Intensität mit einem Schwellenwert
- 112: Pfeil
- 113: Auswerten eines Abklingverhaltens
- 114: Ermitteln von Kontrastunterschieden
- 115: Lokalisieren von Fehlstellen (Rissen)
- 116: Ausgeben der ermittelten Fehlstellen
- 117: Ende

## Patentansprüche

1. Verfahren (100) zum Auffinden von Fehlstellen in einem Halbleiterbauelement (2) mit einem pn-Übergang, insbesondere in einem flächig ausgedehnten Halbleiterbauelement (2), besonders bevorzugt in einer Solarzelle, umfassend die Schritte,
Anlegen einer Spannung an das Halbleiterbauelement (2) mittels einer Spannungsquelle (7);
Erfassen elektromagnetischer Strahlung, die von dem Halbleiterbauelement (2) ausgesandt wird, mittels mindestens eines photoempfindlichen Detektors (13); Auswerten der erfassten elektromagnetischen Strahlung;
**dadurch gekennzeichnet, dass**
die Spannung an das Halbleiterbauelement (2) zunächst so angelegt wird, dass der pn-Übergang in Sperrrichtung betrieben wird, und anschließend die Spannungsrichtung geändert wird, so dass der pn-Übergang des Halbleiterbauelements (2) in Durchlassrichtung betrieben wird, und mit dem photoempfindlichen Detektor (13) eine Intensität einer Lumineszenzstrahlung als die elektromagnetische Strahlung erfasst wird und die zeitlich nach dem Ändern der Spannungsrichtung von einem Betreiben des pn-Übergangs in der Sperrrichtung zu einem Betreiben in der Durchlassrichtung erfasste Intensität ausgewertet wird, wobei eine Fehlstelle anhand einer Intensitätsüberhöhung nach dem Ändern der Spannungsrichtung von der Sperrrichtung auf die Durchlassrichtung erkannt wird.

2. Verfahren (100) nach Anspruch 1, **dadurch gekennzeichnet, dass** ein zeitliches Abklingen der Intensität nach dem Ändern der Spannungsrichtung von der Sperrrichtung auf die Durchlassrichtung untersucht wird und ein Absinken der Lumineszenzintensität als ein Kriterium für ein Vorliegen einer Fehlstelle berücksichtigt wird.

3. Verfahren (100) nach einem der vorangehenden Ansprüche, **dadurch gekennzeichnet, dass** während des Betreibens des Halbleiterbauelements (2) in Sperrrichtung eine Shuntmessung durchgeführt wird, während derer Wärmestrahlung des Halbleiterbauelements (2) als elektromagnetische Strahlung mittels des mindestens einen photoempfindlichen Detektors (13) oder eines weiteren photoempfindlichen Detektors (21) erfasst wird und lokale Wärmeunterschiede ausgewertet werden, wobei insbesondere Wärmeüberhöhungen als Fehlstellen erkannt werden.

4. Verfahren (100) nach einem der vorangehenden Ansprüche, **dadurch gekennzeichnet, dass** der mindestens eine photoempfindliche Detektor (13) die Intensität ortsaufgelöst erfasst, so dass den Fehlstellen, die anhand der Intensitätsüberhöhung der Lumineszenzstrahlung erkannt werden, Positionen auf dem Halbleiterbauelement (2) zugeordnet werden.

5. Verfahren (100) nach einem der vorangehenden Ansprüche, **dadurch gekennzeichnet, dass** die Intensität der Lumineszenzstrahlung ortsaufgelöst mittels einer im nahen infraroten Wellenlängenbereich empfindlichen Kamera in Form von Bildern erfasst wird und mehrere zeitlich nacheinander aufgenommene Bilder vergleichend ausgewertet werden, um Kontrastunterschiede zur Lokalisierung der Fehlstellen auszuwerten.

6. Verfahren (100) nach einem der vorangehenden Ansprüche, **dadurch gekennzeichnet, dass** nicht strahlende Orte des Halbleiterbauelements (2), die in einem Bereich liegen, in dem die Intensitätsüberhöhung der Lumineszenzstrahlung nach dem Ändern der Spannungsrichtung von der Sperrrichtung auf die Durchlassrichtung erkannt wurde, als Orte eines Mikrorisses identifiziert werden.

7. Vorrichtung (1) zum Auffinden von Fehlstellen in einem Halbleiterbauelement (2), insbesondere in einem flächig ausgedehnten Halbleiterbauelement (2), besonders bevorzugt einer Solarzelle (3), umfassend
eine Spannungsquelle (7), die mit Kontakten (11) des Halbleiterbauelements (2) verbindbar ist, um an das Halbleiterbauelement (2) eine Spannung anzulegen; mindestens einen photoempfindlichen Detektor (13) zum Erfassen elektromagnetischer Strahlung, die von dem Halbleitbauerelement (2) ausgesandt wird,
und eine Auswerteeinrichtung (14) zum Auswerten der erfassten von dem Halbleiterbauelement (2) emittierten elektromagnetischen Strahlung,
**dadurch gekennzeichnet, dass**
eine Spannungsrichtungsänderungseinrichtung (12) mit der Spannungsquelle (7) gekoppelt ist oder in die Spannungsquelle (7) integriert ist, über die gezielt die Spannungsrichtung der an das Halbleiterbauelement (2) angelegten Spannung geändert werden kann, so dass von einem Betreiben eines pn-Übergangs des Halbleiterbauelements (2) in Sperrrichtung in ein Betreiben des pn-Übergangs in Durchlassrichtung gewechselt werden kann, und die mit dem mindestens einen photoempfindlichen Detektor (13) gekoppelte Auswerteeinrichtung (14) zum Auswerten einer Intensität einer nach dem Ändern der Spannungsrichtung von der Sperrrichtung auf die Durchlassrichtung als die elektromagnetische Strahlung erfassten Lumineszenzstrahlung ausgebildet ist, wobei die Auswerteeinrichtung (14) ausgebildet ist, eine Fehlstelle anhand einer Intensitätsüberhöhung nach dem Ändern der Spannungsrichtung von der Sperrrichtung auf die Durchlassrichtung zu erkennen.

8. Vorrichtung (1) nach Anspruch 7, **dadurch gekennzeichnet, dass** die Spannungsrichtungsänderungseinrichtung (12) eine Umschalteinrichtung ist,

9. Vorrichtung (1) nach Anspruch 7 oder 8, **dadurch gekennzeichnet, dass** der mindestens eine photoempfindliche Detektor (13) eine im nahen infraroten Wellenlängenbereich empfindliche Kamera ist, die die Intensität der Lumineszenzstrahlung ortsaufgelöst aufnimmt und in Form von Bildern bereitstellt.

10. Vorrichtung (1) nach einem der Ansprüche 7 bis 9, **dadurch gekennzeichnet, dass** die Auswerteeinrichtung (14) ausgebildet ist, ein zeitliches Abklingverhalten der Intensität auszuwerten.

11. Vorrichtung (1) nach einem der Ansprüche 7 bis 10, **dadurch gekennzeichnet, dass** die Auswerteeinrichtung (14) eine Vergleichseinrichtung (15) umfasst, die für eine vergleichende Auswertung von zeitlich nacheinander aufgenommenen Bildern ausgebildet ist.

12. Vorrichtung (1) nach einem der Ansprüche 7 bis 11, **dadurch gekennzeichnet, dass** der mindestens eine photoempfindliche Detektor (13) oder ein weiterer photoempfindlicher Detektor (21) empfindlich für Wärmestrahlung sind und zum ortsaufgelösten Erfassen von Wärmestrahlung ausgebildet sind, während das Halbleiterbauelement (2) in Sperrrichtung betrieben wird, um lokale Wärmeabstrahlungsunterschiede zu erfassen und mit der Auswerteeinrichtung (14) auszuwerten.

13. Vorrichtung (1) nach einem der Ansprüche 7 bis 12, **dadurch gekennzeichnet, dass** die Auswerteeinrichtung (14) ausgebildet ist, nicht strahlende Orte des Halbleiterbauelements (2), die in einem Bereich liegen, in dem die Intensitätsüberhöhung der Lumineszenzstrahlung nach dem Ändern der Spannungsrichtung von der Sperrrichtung auf die Durchlassrichtung erkannt wurde, als Orte eines Mikrorisses zu identifizieren.

## Claims

1. Method (100) for determining defective points in a semiconductor component (2) with a p-n-junction, in particular in a surface-extended semiconductor component (2), for particular preference in a solar cell, comprising the steps of:
imposing a voltage onto the semiconductor component (2) by means of a voltage source (7);
detecting electromagnetic radiation which is emitted by the semiconductor component (2) by means of at least one photosensitive detector (13);
evaluating the electromagnetic radiation emitted,
**characterised in that**
the voltage is first imposed onto the semiconductor component (2) in such a way that the p-n-junction is operated in the non-conductive direction, and then the voltage direction is changed, such that the p-n-junction of the semiconductor component (2) is then operated in the conducting direction, and, with the photosensitive detector (13), an intensity of the luminescence radiation is determined, and the intensity is then evaluated after the temporal change of the voltage direction of the operation of the p-n-junction in the non-conducting direction to operating in the conducting direction, wherein a defective point is identified on the basis of an intensity increase after the change of the voltage direction from the non-conducting direction to the conducting direction.

2. Method (100) according to claim 1, **characterised in that** a temporal decay of the intensity after the change of the voltage direction from the non-conducting direction to the conducting direction is investigated, and a reduction in the luminescence intensity is taken into account as a criterion for the presence of a defective point.

3. Method (100) according to any one of the preceding claims, **characterised in that**, during the operation of the semiconductor component (2) in the non-conducting direction, a shunt measurement is carried out, while the thermal radiation of the semiconductor component (2) is detected as electromagnetic radiation by means of the at least one photosensitive detector (13) or a further photosensitive detector (21), and local heat differences are evaluated, wherein, in particular, heat increases are identified as defective points.

4. Method (100) according to any one of the preceding claims, **characterised in that** the at least one photosensitive detector (13) detects the intensity with location resolution, in such a way that positions on the semiconductor component (2) are assigned to the defective points which are identified on the basis of the intensity increase of the luminescence radiation.

5. Method (100) according to any one of the preceding claims, **characterised in that** the intensity of the luminescence radiation is determined with location resolution by means of a camera, sensitive in the near-infrared wavelength range, in the form of images, and a plurality of images taken in a temporal sequence are evaluated in a comparative sequence, in order to evaluate contrast differences for the localisation of the defective points.

6. Method (100) according to any one of the preceding claims, **characterised in that** non-radiating places of the semiconductor component (2), which lie in an area in which the intensity increase of luminescence radiation has been identified after the change of voltage direction from the non-conducting direction to the conducting direction, are identified as locations of a micro-fissure.

7. Device (1) for determining defective points in a semiconductor component (2), in particular in a surface-extended semiconductor component (2), for particular preference a solar cell (3), comprising:
a voltage source (7) which can be connected to contacts (11) of the semiconductor component (2) in order to impose a voltage on the semiconductor component (2);
at least one photosensitive detector (13) for detecting electromagnetic radiation which is being emitted by the semiconductor component (2),
and an evaluation device (14) for evaluating the electromagnetic radiation detected as emitting from the semiconductor component (2),
**characterised in that**
a device (12) for changing the voltage direction is coupled to the voltage source (7) or integrated into the voltage source (7), by means of which the voltage direction can be specifically changed of the voltage imposed on the semiconductor component (2), such that a change can be made from an operation of a p-n-junction of the semiconductor component (2) in the non-conducting direction into an operation of the p-n-junction in the conducting direction, and the evaluation device (14) coupled to the at least one photosensitive detector (13) is configured for the evaluation of an intensity of a luminescence radiation, detected as the electromagnetic radiation after the changing of the voltage direction from the non-conducting direction to the conducting direction, wherein the evaluation device (14) is configured so as to identify a defective point on the basis of an intensity increase after the change of the voltage direction from the non-conducting direction to the conducting direction.

8. Device (1) according to claim 7, **characterised in that** the device (12) for changing the voltage direction is a changeover device.

9. Device (1) according to claim 7 or 8, **characterised in that** the at least one photosensitive detector (13) is a camera which is sensitive in the near-infrared wavelength range, which records the intensity of the luminescent radiation with location resolution and presents this in the form of images.

10. Device (1) according to any one of claims 7 to 9, **characterised in that** the evaluation device (14) is configured such as to evaluate a temporal decay behaviour of the intensity.

11. Device (1) according to any one of claims 7 to 10, **characterised in that** the evaluation device (14) comprises a comparison device (15), which is configured for a comparative evaluation of images taken in a temporal sequence.

12. Device (1) according to any one of claims 7 to 11, **characterised in that** the at least one photosensitive detector (13) or a further photosensitive detector (21) are sensitive to thermal radiation, and are configured for location resolution detection of thermal radiation, while the semiconductor element (2) is being operated in the non-conducting direction, in order to detect differences in thermal radiation and to evaluate them with the evaluation device (14).

13. Device (1) according to any one of claims 7 to 12, **characterised in that** the evaluation device (14) is configured so as to identify non-irradiating places of the semiconductor element (2) which lie in an area in which the intensity increase of the luminescence radiation has been detected, after the change of voltage direction from the non-conducting direction to the conducting direction, as being the locations of micro-fissures.

## Revendications

1. Procédé (100) de recherche d'endroits défectueux dans un composant semi-conducteur (2) avec une jonction pn, en particulier dans un composant semi-conducteur (2) étendu à plat, particulièrement de préférence dans une cellule solaire, comprenant les étapes de
l'application d'une tension sur le composant semi-conducteur (2) au moyen d'une source de tension (7) ;
la détection d'un rayonnement électromagnétique qui est émis par le composant semi-conducteur (2), au moyen d'au moins un détecteur photosensible (13) ; l'évaluation du rayonnement électromagnétique détecté ;
**caractérisé en ce que**
la tension est appliquée sur le composant semi-conducteur (2) tout d'abord de sorte que la jonction pn fonctionne dans le sens inverse, et ensuite la polarité est modifiée de sorte que la jonction pn du composant semi-conducteur (2) fonctionne dans le sens passant, et avec le détecteur (13) photosensible une intensité d'un rayonnement luminescent est détectée en tant que rayonnement électromagnétique et l'intensité détectée temporellement après la modification de la polarité d'un fonctionnement de la jonction pn dans le sens inverse à un fonctionnement dans le sens passant est évaluée, dans lequel un endroit défectueux est reconnu à l'aide d'une surélévation d'intensité après la modification de la polarité du sens inverse au sens passant.

2. Procédé (100) selon la revendication 1, **caractérisé en ce qu'**un évanouissement temporel de l'intensité est examiné après la modification de la polarité du sens inverse au sens passant et une diminution de l'intensité de luminescence est prise en considération en tant que critère pour une présence d'un endroit défectueux.

3. Procédé (100) selon l'une quelconque des revendications précédentes, **caractérisé en ce que** pendant le fonctionnement du composant semi-conducteur (2) dans le sens inverse une mesure shunt est réalisée, pendant laquelle le rayonnement thermique du composant semi-conducteur (2) est détecté en tant que rayonnement électromagnétique au moyen d'au moins un détecteur (13) photosensible ou d'un autre détecteur (21) photosensible et des différences thermiques locales sont évaluées, dans lequel en particulier des surélévations thermiques sont détectées en tant qu'endroits défectueux.

4. Procédé (100) selon l'une quelconque des revendications précédentes, **caractérisé en ce que** l'au moins un détecteur photosensible (13) détecte l'intensité par résolution spatiale de sorte que des positions sur le composant semi-conducteur (2) soient associées aux endroits défectueux qui sont reconnus au moyen de la surélévation d'intensité du rayonnement luminescent.

5. Procédé (100) selon l'une quelconque des revendications précédentes, **caractérisé en ce que** l'intensité du rayonnement luminescent est détectée par résolution spatiale au moyen d'une caméra sensible dans la plage de longueur d'onde à infrarouge proche sous la forme d'images et plusieurs images prises temporellement les unes après les autres sont évaluées par comparaison afin d'évaluer des différences de contraste pour la localisation des endroits défectueux.

6. Procédé (100) selon l'une quelconque des revendications précédentes, **caractérisé en ce que** des lieux non rayonnants du composant semi-conducteur (2) qui se trouve dans une zone dans laquelle la surélévation d'intensité du rayonnement luminescent a été reconnue après la modification de la polarité du sens inverse au sens passant, sont identifiés en tant que lieux d'une microfissure.

7. Dispositif (1) de recherche d'endroits défectueux dans un composant semi-conducteur (2), en particulier dans un composant semi-conducteur (2) étendu à plat, particulièrement de préférence d'une cellule solaire (3), comprenant
une source de tension (7) qui peut être raccordée aux contacts (11) du composant semi-conducteur (2) afin d'appliquer une tension sur le composant semi-conducteur (2) ;
au moins un détecteur (13) photosensible pour la détection d'un rayonnement électromagnétique qui est émis par le composant semi-conducteur (2),
et un dispositif d'évaluation (14) pour l'évaluation du rayonnement électromagnétique détecté émis par le composant semi-conducteur (2),
**caractérisé en ce que**
un dispositif de modification de polarité (12) est couplé à la source de tension (7) ou intégré dans la source de tension (7), par le biais duquel la polarité de la tension appliquée sur le composant semi-conducteur (2) peut être modifiée de manière ciblée de sorte qu'on puisse passer d'un fonctionnement d'une jonction pn du composant semi-conducteur (2) dans le sens inverse à un fonctionnement de la jonction pn dans le sens passant, et le dispositif d'évaluation (14) couplé à l'au moins un détecteur (13) photosensible est réalisé pour l'évaluation d'une intensité d'un rayonnement luminescent détecté après la modification de la polarité du sens inverse au sens passant en tant que rayonnement électromagnétique, dans lequel le dispositif d'évaluation (14) est réalisé afin de reconnaître un endroit défectueux au moyen d'une surélévation d'intensité après la modification de la polarité du sens inverse au sens passant.

8. Dispositif (1) selon la revendication 7, **caractérisé en ce que** le dispositif de modification de polarité (12) est un dispositif de commutation.

9. Dispositif (1) selon la revendication 7 ou 8, **caractérisé en ce que** l'au moins un détecteur (13) photosensible est une caméra sensible dans la plage de longueur d'onde à infrarouge proche qui reçoit l'intensité du rayonnement luminescent par résolution spatiale et la met à disposition sous la forme d'images.

10. Dispositif (1) selon l'une quelconque des revendications 7 à 9, **caractérisé en ce que** le dispositif d'évaluation (14) est réalisé afin d'évaluer un comportement d'évanouissement temporel de l'intensité.

11. Dispositif (1) selon l'une quelconque des revendications 7 à 10, **caractérisé en ce que** le dispositif d'évaluation (14) comporte un dispositif de comparaison (15) qui est réalisé pour une évaluation comparative d'images prises temporellement les unes après les autres.

12. Dispositif (1) selon l'une quelconque des revendications 7 à 11, **caractérisé en ce que** l'au moins un détecteur (13) photosensible ou un autre détecteur (21) photosensible est sensible au rayonnement thermique et est réalisé pour la détection par résolution spatiale de rayonnement thermique alors que le composant semi-conducteur (2) fonctionne dans le sens inverse afin de détecter des différences de rayonnement thermique locales et de les évaluer avec le dispositif d'évaluation (14).

13. Dispositif (1) selon l'une quelconque des revendications 7 à 12, **caractérisé en ce que** le dispositif d'évaluation (14) est réalisé afin d'identifier des lieux non rayonnants du composant semi-conducteur (2) qui se trouvent dans une zone dans laquelle la surélévation d'intensité du rayonnement luminescent a été reconnue après la modification de la polarité du sens inverse au sens passant, en tant que lieux d'une micro fissure.
